# EUROPÄISCHE PATENTSCHRIFT

(11) **EP 3 213 412 B1**
(45) Veröffentlichungstag und Bekanntmachung des Hinweises auf die Patenterteilung: **21.08.2019**
(21) Anmeldenummer: 15770907.2
(22) Anmeldetag: 29.09.2015
(51) Int. Cl.: H03K 17/968

(54) **SCHALTVORRICHTUNG FÜR EIN STEUERSYSTEM FÜR EIN FAHRZEUG UND STEUERSYSTEM FÜR EIN FAHRZEUG**
SWITCHING APPARATUS FOR A CONTROL SYSTEM FOR A VEHICLE, AND CONTROL SYSTEM FOR A VEHICLE
DISPOSITIF DE COMMUTATION POUR UN SYSTÈME DE COMMANDE POUR UN VÉHICULE ET SYSTÈME DE COMMANDE POUR UN VÉHICULE

(30) Priorität: 29.10.2014 DE 102014221986
(43) Veröffentlichungstag der Anmeldung: 06.09.2017
(73) Patentinhaber: ZF Friedrichshafen AG, 88046 Friedrichshafen (DE); Lemförder Electronic GmbH, 32339 Espelkamp (DE)
(72) Erfinder: PEUKERT, Andreas, 49406 Barnstorf (DE); PFEIFER, Ralf, 49356 Diepholz (DE)
(86) Internationale Anmeldenummer: PCT/EP2015/072343
(87) Internationale Veröffentlichungsnummer: WO 2016/066356

(56) Entgegenhaltungen:
- EP-A1- 0 538 502
- WO-A1-00/68719
- WO-A1-89/09515
- WO-A1-94/29671
- US-A- 3 886 544

## Beschreibung

Die vorliegende Erfindung bezieht sich auf eine Schaltvorrichtung für ein Steuersystem für ein Fahrzeug und auf ein Steuersystem für ein Fahrzeug mit einer solchen Schaltvorrichtung, insbesondere für ein Bedienelement, beispielsweise einer Fahrstufen-Wähleinrichtung eines Fahrzeugs.

Beispielsweise bei Wählhebeln mit elektronischen Komponenten kann aufgrund von Designwünschen von Kunden ein aufwendiger Bau eines Wählhebels nötig sein. Dabei kann beispielsweise eine Hauptplatine in einer Basis des Wählhebels benötigt werden und können eine oder auch mehrere Hilfsplatinen in einem Schaltgriff oder Knauf benötigt werden. Eine solche Hilfsplatine im Knauf kann insbesondere Schalter, wie beispielsweise eine P-Taste zum Einlegen einer Parkstellung eines Getriebes, eine Entriegelungstaste zum Verlassen der Parkstellung und eine Taste zur Aktivierung eines manuellen Modus bzw. einer manuellen Gasse oder Tippgasse, sowie Leuchtdioden für eine Anzeige von Fahrstufen und eine Hintergrundbeleuchtung tragen. Da im Knauf üblicherweise zu wenig Platz zur Verfügung steht, können hier unter Umständen nicht alle Komponenten untergebracht werden, was beispielsweise eine solche Zweiteilung oder Aufteilung erforderlich machen kann. Hauptplatine und Hilfsplatine sind üblicherweise elektrisch leitfähig miteinander zu verbinden.

Die DE 10 2008 001 884 A1 offenbart eine Betätigungseinrichtung mit Lichtleiterbündel.

Die WO 00/68719 offenbart eine Schaltvorrichtung umfassend mehrere Lichtleiter, wobei in Abhängigkeit eines Schaltzustands eines Schalters der Schaltvorrichtung ein Lichtsignal einem oder mehreren der Lichtleiter zugeführt wird.

Die EP 0 538 502 A1 zeigt einen mehrstufigen Taster mit magnetischer Auswertung der Schaltpositionen.

Die WO 94/29671 A1 zeigt einen auf dem Biegeradius eines durchgängigen Lichtleiters basierenden Positionssensor.

Vor diesem Hintergrund schafft die vorliegende Erfindung eine verbesserte Schaltvorrichtung für ein Steuersystem für ein Fahrzeug gemäß dem unabhängigen Anspruch 1. Vorteilhafte Ausgestaltungen ergeben sich aus den Unteransprüchen und der nachfolgenden Beschreibung.

Gemäß Ausführungsformen der vorliegenden Erfindung kann insbesondere eine optische bzw. optoelektronische Überwachung von peripher anordenbaren Schaltvorrichtungen realisiert werden, die als mehrstufiger Taster oder Schalter bzw. Stufentaster oder Stufenschalter ausgeführt sind. Dabei können beispielsweise Lichtleiter und unterschiedliche vorteilhafte Mechanismen zur Übertragung von Schaltstellungen auf ein lichtleitergeführtes optisches Signal zum Einsatz kommen. Anders ausgedrückt können Lichtschalter zur Überwachung von peripher anordenbaren Schaltvorrichtungen verwendet werden.

Vorteilhafterweise kann gemäß Ausführungsformen der vorliegenden Erfindung insbesondere eine Schaltvorrichtung auf sichere, platzsparende und flexibel an Designwünsche bzw. Kundenwünsche anpassbare Weise beabstandet von einem Steuergerät und/oder unter anspruchsvollen geometrischen Bedingungen untergebracht, optoelektronisch überwacht und optisch an das Steuergerät angebunden werden. So können beispielsweise bei verteilten Schaltvorrichtungen bzw. Bedienelementen elektrische Komponenten bzw. Funktionen einzig auf einer Hauptplatine angeordnet sein.

Eine solche optische Anbindung einer peripher anordenbaren, mehrstufigen Schaltvorrichtung an eine zentral anordenbare Steuereinheit kann Vorteile bieten, weil Lichtleiter unempfindlich gegen elektrische und magnetische Störungen sind. Ferner können peripher anordenbare Elektronikkomponenten beispielsweise in einem Knauf eines Schalthebels für ein Fahrzeuggetriebe entfallen. Peripher anordenbare Taster oder Schalter können dabei ohne elektrische Komponenten auskommen. Ferner ist lediglich eine zentrale Steuereinheit hinsichtlich für Elektronik geltender Sicherheitsbestimmungen auszulegen. Schließlich kann eine hohe Ausfallsicherheit und Zuverlässigkeit aufgrund des Wegfalls von Hilfsplatine und Kabel erreicht werden.

Insbesondere kann auch eine Produktsicherheit erhöht werden, da Komponenten ersetzt werden können, die sicherheitsrelevant sein könnten und besondere Risiken in ein Steuersystem bringen könnten. Insbesondere bei Steuersystemen mit verteilt angeordneten, peripheren Schaltvorrichtungen bzw. Komponenten kann eine Reduktion von Entwicklungskosten sowie von Stückkosten erreicht werden, da eine funktionale Sicherheit lediglich in dem zentralen Steuergerät realisiert zu werden braucht und da zum Vernetzen der Systemkomponenten beispielsweise lediglich Lichtleiter und Bündeladapter erforderlich sind sowie eine ansonsten vorzusehende Abdichtung für periphere Elektronik reduziert werden kann. Auch können bessere diagnostische Maßnahmen umgesetzt werden, weil aufgrund der optischen Anbindung von zumindest einer Schaltvorrichtung an ein Steuergerät eine universelle und zuverlässige Diagnose ohne Einschränkungen hinsichtlich unterschiedlicher elektrischer Spezifikationen der Komponenten möglich ist.

Verglichen mit einer elektrischen Vernetzung kann durch die optische Vernetzung gemäß Ausführungsformen der vorliegenden Erfindung insbesondere ein Aufwand an Teilen und Kosten gesenkt werden. Es kann ferner beispielsweise das Problem umgangen werden, dass elektrische Kabelstränge nicht beliebig viele Adern haben können, da insbesondere Stecker ansonsten entsprechend sehr groß werden, sodass oft nur Flachstecker möglich sind, jedoch ein Bauraum begrenzt sein kann. Insbesondere bei einer Anwendung in Verbindung mit einem Schalthebel bzw. Gangwahlhebel für ein Fahrzeuggetriebe bzw. einen Fahrzeugantrieb kann eine Schaltstange einen begrenzten Innendurchmesser aufweisen und können beispielsweise Schaltsäcke, welche solche elektrischen Kabel verbergen könnten, von Kunden nicht immer gewünscht sein. Somit kann gemäß Ausführungsformen der vorliegenden Erfindung eine Anpassbarkeit an begrenzte oder komplexe Geometrien verbessert werden bzw. kann eine Designfreiheit gesteigert werden. Da beispielsweise keine Systemkomponenten vernetzende und/oder periphere Elektrik mehr beispielsweise gegen ein Verschütten von Flüssigkeiten zu schützen ist, kann auch ein Aufwand zum Abdichten des Steuersystems gesenkt werden. Ebenso braucht zur Anbindung von peripheren Komponenten zum Beispiel keine Flexfolie eingesetzt zu werden, die einerseits besonderer konstruktiver Auslegung bedarf, um nicht vorzeitig auszufallen, aber andererseits eine herkömmlicherweise eingesetzte Hilfsplatine ohnehin nicht in allen Anwendungen ersetzen könnte. Da es gemäß Ausführungsformen der Erfindung insbesondere vermieden werden kann, sicherheitsrelevante Funktionen auf einer gemäß Ausführungsformen der Erfindung obsoleten Hilfsplatine bereitzustellen, ist eine besonders unaufwendige Entwicklung und Realisierung von Steuersystemen ermöglicht.

Eine Schaltvorrichtung für ein Steuersystem für ein Fahrzeug weist die Merkmale des unabhängigen Anspruchs 1 auf.

Bei dem Fahrzeug kann es sich um ein Landfahrzeug, ein Wasserfahrzeug oder ein Luftfahrzeug handeln, insbesondere um ein straßengebundenes Kraftfahrzeug, beispielsweise einen Personenkraftwagen, einen Lastkraftwagen oder ein sonstiges Nutzfahrzeug. Die Schaltvorrichtung kann ein Taster oder ein Schalter sein, insbesondere ein mehrstufiger Taster oder Schalter, beispielsweise ein Stufentaster, Wipptaster, ein Schiebeschalter oder dergleichen. Die Betätigungskraft kann von einer Bedienperson auf das Bedienelement der Schaltvorrichtung ausübbar sein. Dabei ist das Bedienelement bei Anliegen der Betätigungskraft von der Grundstellung aus in die erste Betätigungsstellung und von der ersten Betätigungsstellung aus in die zweite Betätigungsstellung bewegbar. Bei nachfolgender Abwesenheit der Betätigungskraft kann das Bedienelement von der zweiten Betätigungsstellung aus oder der ersten Betätigungsstellung aus in die Grundstellung rückstellend oder rückstellbar sein. Der zumindest eine Lichtleiter kann als ein Lichtleiterbündel oder als Teil eines Lichtleiterbündels ausgeführt sein. Das Bedienelement kann auch in zumindest eine weitere Betätigungsstellung bewegbar sein. Die Einstelleinrichtung kann ausgebildet sein, um die Charakteristik des Lichtsignals in den einzelnen Betätigungsstellungen unterschiedlich und gegebenenfalls in einer der Betätigungsstellungen nicht zu beeinflussen. Dabei kann die Einstelleinrichtung ausgebildet sein, um in der zumindest einen weiteren Betätigungsstellung die Ausgangscharakteristik des Lichtsignals auf zumindest einen weiteren Wert einzustellen. Der zumindest eine Lichtleiter kann auch Teil des Steuersystems sein, wobei der zumindest eine Lichtleiter getrennt von der Schaltvorrichtung bereitstellbar sein kann.

Erfindungsgemäß weist die Einstelleinrichtung zumindest einen Druckabschnitt auf, der ausgebildet ist, um abhängig von einer Stellung des Bedienelements einen Krümmungsradius des zumindest einen Lichtleiters zu verändern. Der zumindest eine Lichtleiter ist hierbei als zumindest ein durchgehender Lichtleiter ausgeführt, der sich von einer Eintrittsseite der Schaltvorrichtung zu einer Austrittsseite der Schaltvorrichtung erstreckt. Der zumindest eine Druckabschnitt kann als ein Vorsprungsabschnitt des Bedienelements ausgeformt sein. In der Grundstellung kann der zumindest eine Druckabschnitt beispielsweise von dem zumindest einen Lichtleiter beabstandet sein und in den Betätigungsstellungen kann der zumindest eine Lichtschalter beispielsweise durch den zumindest einen Druckabschnitt verbiegbar sein. Dies bietet den Vorteil, dass das Lichtsignal abhängig von einer Stellung des Bedienelements durch Lichtauskopplung unterschiedlich gedämpft werden kann, sodass auf zuverlässige und konstruktiv einfache Weise unterschiedliche Werte der Ausgangscharakteristik eingestellt werden können und ein günstiges Schaltverhalten der Schaltvorrichtung erreicht werden kann.

Die Einstelleinrichtung kann zumindest einen Dämpferabschnitt aufweisen, der ausgebildet ist, um abhängig von einer Stellung des Bedienelements das Lichtsignal in dem zumindest einen Lichtleiter mindestens teilweise durchzulassen und zusätzlich oder alternativ mindestens teilweise zu dämpfen oder zu unterbrechen. In einem nicht zur Erfindung gehörenden Beispiel kann der zumindest eine Lichtleiter zumindest einen ersten Lichtleiter und zumindest einen zweiten Lichtleiter aufweisen. Dabei kann sich der zumindest eine erste Lichtleiter von einer Eintrittseite der Schaltvorrichtung ein erstes Teilstück durch die Schaltvorrichtung erstrecken und kann sich der zumindest eine zweite Lichtleiter ein zweites Teilstück durch die Schaltvorrichtung bis zu einer Austrittseite der Schaltvorrichtung erstrecken. Zwischen dem zumindest einen ersten Lichtleiter und dem zumindest einen zweiten Lichtleiter kann ein Zwischenraum angeordnet sein. Der zumindest eine Dämpferabschnitt kann ausgebildet sein, um abhängig von einer Stellung des Bedienelements in den Zwischenraum zwischen den Lichtleitern bewegbar zu sein oder in dem Zwischenraum verschiebbar zu sein. Ein solches nicht zur Erfindung gehörendes Beispiel bietet den Vorteil, dass auch auf diese Weise unterschiedliche Werte der Ausgangscharakteristik sicher und konstruktiv einfach eingestellt werden können, um ein Schaltverhalten der Schaltvorrichtung zu verbessern.

Dabei kann der zumindest eine Dämpferabschnitt einen Unterbrechungsabschnitt, ein optisches Element, einen Reflektor und zusätzlich oder alternativ einen Absorber aufweisen. Der Unterbrechungsabschnitt kann aus einem optisch intransparenten und zusätzlich oder alternativ nicht-reflektierenden Material ausgeformt sein. Der Reflektor kann aus einem optisch reflektierenden Material ausgeformt sein. Der Absorber kann aus einem optisch nicht-reflektierenden Material mit matter Oberfläche ausgeformt sein. Insbesondere kann der zumindest eine Dämpferabschnitt einen Reflektor und mindestens einen Absorber und zusätzlich oder alternativ einen Unterbrechungsabschnitt aufweisen, wobei eine Längserstreckungsachse des zumindest einen ersten Lichtleiters und eine Längserstreckungsachse des zumindest einen zweiten Lichtleiters quer zueinander verlaufen können. Alternativ kann der zumindest eine Dämpferabschnitt einen Unterbrechungsabschnitt und optional ein optisches Element aufweisen. Eine solche Ausführungsform bietet den Vorteil, dass die Dämpfung des optischen Signals bzw. die unterschiedlichen Werte der Ausgangscharakteristik und somit das günstige Schaltverhalten der Schaltvorrichtung auf flexibel an eine Geometrie an einem Einbauort anpassbare Weise realisiert werden kann.

Auch kann die Einstelleinrichtung zumindest einen weiteren Lichtleiter aufweisen, der ausgebildet ist, um abhängig von einer Stellung des Bedienelements das Lichtsignal in dem zumindest einen Lichtleiter mindestens teilweise durchzulassen und zusätzlich oder alternativ mindestens teilweise zu dem Bedienelement umzuleiten. Hierbei kann der zumindest eine Lichtleiter zumindest einen ersten Lichtleiter und zumindest einen zweiten Lichtleiter aufweisen. Dabei kann sich der zumindest eine erste Lichtleiter von einer Eintrittseite der Schaltvorrichtung ein erstes Teilstück durch die Schaltvorrichtung erstrecken und kann sich der zumindest eine zweite Lichtleiter ein zweites Teilstück durch die Schaltvorrichtung bis zu einer Austrittseite der Schaltvorrichtung erstrecken. Zwischen dem zumindest einen ersten Lichtleiter und dem zumindest einen zweiten Lichtleiter kann ein Zwischenraum angeordnet sein. Der zumindest eine weitere Lichtleiter kann ausgebildet sein, um abhängig von einer Stellung des Bedienelements in den Zwischenraum zwischen den Lichtleitern bewegbar zu sein oder in dem Zwischenraum verschiebbar zu sein. Der zumindest eine weitere Lichtleiter kann ausgebildet sein, um ein zu dem Bedienelement umgeleitetes Lichtsignal einer Beleuchtungseinrichtung bereitzustellen. Eine solche Ausführungsform bietet den Vorteil, dass auf konstruktiv einfache Weise nicht nur unterschiedliche Werte der Ausgangscharakteristik zuverlässig eingestellt werden können, um ein Schaltverhalten der Schaltvorrichtung zu verbessern, sondern auch eine Beleuchtung der Schaltvorrichtung bzw. des Bedienelements realisiert werden kann.

In einem nicht zur Erfindung gehörenden Beispiel kann die Einstelleinrichtung zumindest einen Filter aufweisen, der ausgebildet ist, um abhängig von einer Stellung des Bedienelements das Lichtsignal in dem zumindest einen Lichtleiter mindestens teilweise ungefiltert durchzulassen und zusätzlich oder alternativ mindestens teilweise zu filtern. Hierbei kann der zumindest eine Lichtleiter zumindest einen ersten Lichtleiter und zumindest einen zweiten Lichtleiter aufweisen. Dabei kann sich der zumindest eine erste Lichtleiter von einer Eintrittseite der Schaltvorrichtung ein erstes Teilstück durch die Schaltvorrichtung erstrecken und kann sich der zumindest eine zweite Lichtleiter ein zweites Teilstück durch die Schaltvorrichtung bis zu einer Austrittseite der Schaltvorrichtung erstrecken. Zwischen dem zumindest einen ersten Lichtleiter und dem zumindest einen zweiten Lichtleiter kann ein Zwischenraum angeordnet sein. Der zumindest eine Filter kann ausgebildet sein, um abhängig von einer Stellung des Bedienelements in den Zwischenraum zwischen den Lichtleitern bewegbar zu sein oder in dem Zwischenraum verschiebbar zu sein. Der zumindest eine Filter kann ein Polfilter oder ein Farbfilter sein. Eine solche Ausführungsform bietet den Vorteil, dass auch eine Veränderung des Lichtsignals mittels Filterns gut unterscheidbare Werte der Ausgangscharakteristik zum Erreichen eines günstigen Schaltverhaltens der Schaltvorrichtung liefern kann.

Gemäß einem Ausführungsbeispiel können die Eingangscharakteristik und die Ausgangscharakteristik des Lichtsignals eine Lichtintensität oder einen Lichtstrom repräsentieren. Die Lichtintensität kann sich auf eine Beleuchtungsstärke, eine spezifische Lichtausstrahlung, eine Leuchtdichte, eine Lichtstärke, einen Lichtfluss, eine Lichtmenge, eine Belichtung oder eine Lichtausbeute beziehen. Alternativ können die Eingangscharakteristik und die Ausgangscharakteristik des Lichtsignals eine Polarisationseigenschaft, eine Farbe oder dergleichen sein. Eine solche Ausführungsform bietet den Vorteil, dass anhand solcher Charakteristika auf einfache Weise unterscheidbare Werte der Ausgangscharakteristik des Lichtsignals erzeugbar sind, was ein günstiges Schaltverhalten der Schaltvorrichtung ermöglicht.

Insbesondere kann der erste Wert der Ausgangscharakteristik einen maximalen Wert repräsentieren. Hierbei kann der dritte Wert der Ausgangscharakteristik einen minimalen Wert repräsentieren. Der zweite Wert der Ausgangscharakteristik kann dabei einen Zwischenwert zwischen dem maximalen Wert und dem minimalen Wert repräsentieren. Beispielsweise kann dabei die Ausgangscharakteristik eine Lichtintensität oder einen Lichtstrom repräsentieren. Eine solche Ausführungsform bietet den Vorteil, dass ein Vorliegen eines maximalen Lichtflusses oder dergleichen in der Grundstellung bzw. in einer Ruheposition eine zyklische Diagnose optischer Komponenten erleichtert oder ermöglicht, insbesondere im Falle eines Tasters als Schaltvorrichtung. Alternativ kann der erste Wert der Ausgangscharakteristik einen minimalen Wert repräsentieren und kann der der dritte Wert der Ausgangscharakteristik einen maximalen Wert repräsentieren.

Ferner weist die Schaltvorrichtung zumindest eine Federeinrichtung zum Anlegen einer der Betätigungskraft entgegengerichteten Federkraft an das Bedienelement auf. Die Federeinrichtung ist erfindungsgemäß ausgebildet, um eine mehrstufige Bewegung des Bedienelements zwischen der Grundstellung, der ersten Betätigungsstellung und der zweiten Betätigungsstellung zu regulieren. Optional kann die Schaltvorrichtung eine Mehrzahl von Federeinrichtungen mit unterschiedlichen Federkonstanten bzw. ausübbaren Federkräften aufweisen. Die zumindest eine Federeinrichtung kann beispielsweise eine Tellerfeder aufweisen. Eine solche Ausführungsform bietet den Vorteil, dass die Mehrstufigkeit einer Schaltbewegung der Schaltvorrichtung bzw. des Bedienelements auf konstruktiv einfache und hinsichtlich eines Bewegungsweges des Bedienelements präzise definierbare Weise realisiert werden kann.

Dabei können in der Grundstellung das Bedienelement und die zumindest eine Federeinrichtung kraftmäßig entkoppelt sein. In der ersten Betätigungsstellung kann eine Kraftübertragung zwischen dem Bedienelement und der zumindest einen Federeinrichtung minimal sein. In der zweiten Betätigungsstellung kann eine Kraftübertragung zwischen dem Bedienelement und der zumindest einen Federeinrichtung maximal sein. Dabei kann die zumindest eine Federeinrichtung ausgebildet sein, um auf das Bedienelement bei der minimalen Kraftübertragung eine minimale Federkraft und bei der maximalen Kraftübertragung eine maximale Federkraft auszuüben. Eine solche Ausführungsform bietet den Vorteil, dass eine mindestens zweistufige Schaltbewegung des Bedienelements auf konstruktiv einfache und für einen Benutzer haptisch eindeutige Weise realisiert werden kann.

Auch kann das Bedienelement eine Taste, einen Schalter, eine Wipptaste, einen Wippschalter oder einen Schieber aufweisen. Eine solche Ausführungsform bietet den Vorteil, dass eine Vielfalt von Anwendungsmöglichkeiten bzw. Ausgestaltungsmöglichkeiten für die Schaltvorrichtung zur Auswahl steht.

Gemäß der Erfindung weist die Schaltvorrichtung einen durchgehenden Lichtleiter und zumindest eine Federeinrichtung zum Anlegen einer der Betätigungskraft entgegengerichteten Federkraft an das Bedienelement auf. Hierbei ist die Federeinrichtung ausgebildet, um eine mehrstufige Bewegung des Bedienelements zwischen der Grundstellung, der ersten Betätigungsstellung und der zweiten Betätigungsstellung zu regulieren. Dabei weist die Einstelleinrichtung zumindest einen Druckabschnitt auf, der ausgebildet ist, um abhängig von einer Stellung des Bedienelements einen Krümmungsradius des zumindest einen Lichtleiters zu verändern. Hierbei kann der Lichtleiter zwischen dem zumindest einen Druckabschnitt und der Federeinrichtung angeordnet sein. Eine solche Ausführungsform bietet den Vorteil, dass eine Platz sparende und kostengünstige Schaltvorrichtung mit einer reduzierten Teileanzahl bereitgestellt werden kann.

Ein Steuersystem für ein Fahrzeug weist folgende Merkmale auf:
eine Ausführungsform der vorstehend genannten Schaltvorrichtung; und
ein Steuergerät, wobei die Schaltvorrichtung mittels des zumindest einen Lichtleiters datenübertragungsfähig mit dem Steuergerät verbunden ist, wobei das Steuergerät eine Einrichtung zum Einkoppeln des Lichtsignals mit der Eingangscharakteristik in den zumindest einen Lichtleiter und eine Einrichtung zum Erfassen der Ausgangscharakteristik des Lichtsignals aus dem zumindest einen Lichtleiter aufweist, wobei das Steuergerät ausgebildet ist, um abhängig von einem Wert der Ausgangscharakteristik des Lichtsignals ein Steuersignal zu erzeugen.

In Verbindung mit dem Steuersystem kann eine Ausführungsform der vorstehend genannten Schaltvorrichtung vorteilhaft verwendet werden, um unterschiedliche Werte der Ausgangscharakteristik des Lichtsignals bereitzustellen, auf deren Grundlage ein Steuersignal bzw. Schaltsignal erzeugbar ist. Das Steuersystem kann zumindest eine solche Schaltvorrichtung aufweisen. Das Steuergerät kann eine Leiterplatte aufweisen oder an einer Leiterplatte angeordnet oder anordenbar sein. Die Einrichtung zum Einkoppeln kann eine Lichtquelle, insbesondere eine Leuchtdiode aufweisen. Die Einrichtung zum Erfassen kann einen Fototransistor oder dergleichen aufweisen. Der zumindest eine Lichtleiter kann hierbei als eine geschlossene oder offene Schleife von dem Steuergerät durch die Schaltvorrichtung hindurch zurück zu dem Steuergerät ausgeführt sein.

Gemäß einer Ausführungsform kann das Steuergerät ausgebildet sein, um das Steuersignal an eine Schnittstelle zu einer Motorsteuervorrichtung und zusätzlich oder alternativ an eine Schnittstelle zu einer Getriebesteuervorrichtung auszugeben. Das Steuersignal kann geeignet sein, um eine bei einer Verarbeitung durch die Motorsteuervorrichtung und zusätzlich oder alternativ die Getriebesteuervorrichtung eine Steuerung oder Regelung eines Betriebs derselben zu bewirken. Eine solche Ausführungsform bietet den Vorteil, dass unter Verwendung des aufgrund des Ausgangscharakteristikwertes aus der Schaltvorrichtung erzeugten Steuersignals auch ein Fahrzeuggetriebe und/oder ein Fahrzeugantrieb gesteuert werden können.

Dabei kann das Steuergerät ausgebildet sein, um ansprechend auf den zweiten Wert der Ausgangscharakteristik ein erstes Steuersignal zu erzeugen, das ein Vorwahlsignal zum Vorwählen einer Getriebestufe repräsentiert, und ansprechend auf den dritten Wert der Ausgangscharakteristik ein zweites Steuersignal zu erzeugen, das ein Schaltsignal zum Einstellen einer Getriebestufe repräsentiert. Eine solche Ausführungsform bietet den Vorteil, dass aufgrund der Tatsache, dass für einen Schaltvorgang in einen anderen Gang oder eine andere Getriebestufe beispielsweise bei vielen Getriebearten auf eine andere Nebenwelle des Getriebes gewechselt wird, bereits eine korrekte und hilfreiche Vorabinformation für eine Getriebesteuerung bereitgestellt werden kann, sodass auch eine ansonsten gegebenenfalls fällige Korrektur einer abgeschätzten Vorwahl vermieden werden kann und Zeit eingespart wird, insbesondere auch damit ein Fahrer beispielsweise zur Vorbereitung eines Überholmanövers mit Gangvorwahl eine schnelle Schaltung vorbereiten kann.

Auch kann das Steuergerät ausgebildet sein, um ansprechend auf den zweiten Wert der Ausgangscharakteristik ein erstes Steuersignal zu erzeugen, das ein Motorstartsignal repräsentiert, und ansprechend auf den dritten Wert der Ausgangscharakteristik ein zweites Steuersignal zu erzeugen, das ein Entriegelungssignal zum Lösen einer Getriebeverriegelung repräsentiert. Eine solche Ausführungsform bietet den Vorteil, dass auch an sich unterschiedliche Fahrzeugfunktionen durch die mehrstufige Schaltvorrichtung des Steuersystems ansteuerbar sind, wobei so eine sinnvolle Zusammenführung von Funktionalitäten sowie eine vereinfachte Bedienbarkeit des Fahrzeugs erreichbar sind.

Die Erfindung wird anhand der beigefügten Zeichnungen beispielhaft näher erläutert. Es zeigen:
Fig. 1 ein Steuersystem mit einer Schaltvorrichtung gemäß einem Ausführungsbeispiel der vorliegenden Erfindung; und
Figuren 2A bis 3B Schaltvorrichtungen gemäß Ausführungsbeispielen der vorliegenden Erfindung.
Figuren 4 bis 7B: nicht zur Erfindung gehörende beispielhafte Ausführungsformen.

In der nachfolgenden Beschreibung bevorzugter Ausführungsbeispiele der vorliegenden Erfindung werden für die in den verschiedenen Figuren dargestellten und ähnlich wirkenden Elemente gleiche oder ähnliche Bezugszeichen verwendet, wobei auf eine wiederholte Beschreibung dieser Elemente verzichtet wird.

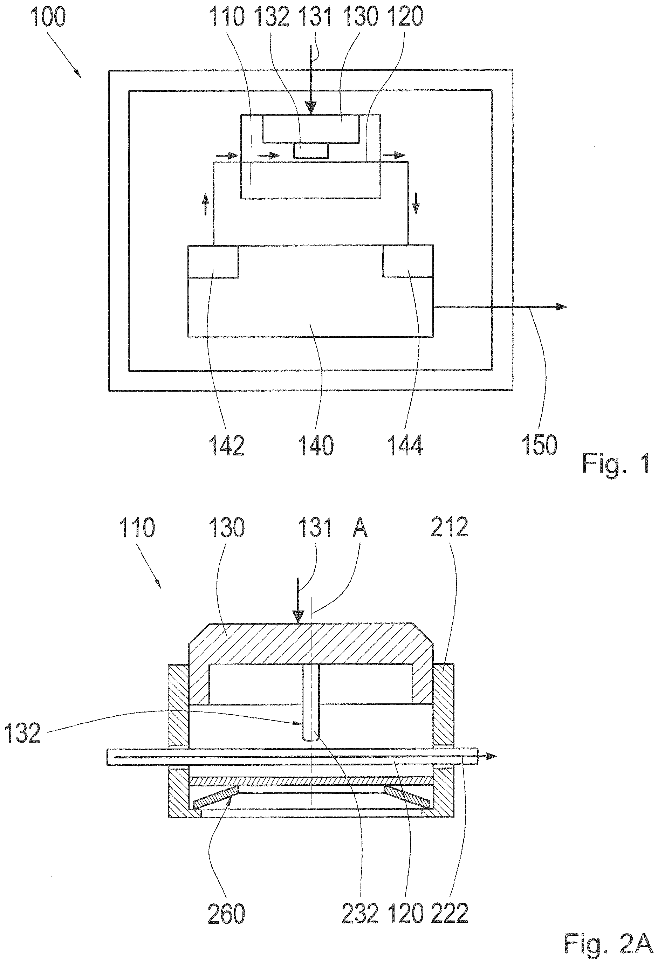

Fig. 1 zeigt ein Steuersystem 100 mit einer Schaltvorrichtung 110 gemäß einem Ausführungsbeispiel der vorliegenden Erfindung. Das Steuersystem 100 ist zur Verwendung für ein Fahrzeug vorgesehen bzw. in Verbindung mit einem Fahrzeug verwendbar. Beispielsweise ist das Steuersystem 100 verwendbar, um ein Fahrzeuggetriebe und zusätzlich oder alternativ einen Fahrzeugantrieb zu steuern.

Das Steuersystem 100 weist gemäß dem in Fig. 1 dargestellten Ausführungsbeispiel der vorliegenden Erfindung eine Schaltvorrichtung 110 auf. Gemäß einem anderen Ausführungsbeispiel kann das Steuersystem 100 eine Mehrzahl von Schaltvorrichtungen 110 aufweisen.

Die Schaltvorrichtung 110 weist gemäß dem in Fig. 1 dargestellten Ausführungsbeispiel der vorliegenden Erfindung einen Lichtleiter 120 auf. Der Lichtleiter 120 ist ausgebildet, um ein Lichtsignal zu leiten. Eine Ausbreitungsrichtung des Lichtsignals ist in Fig. 1 durch Pfeile symbolisch veranschaulicht. Der Lichtleiter 120 erstreckt sich durch die Schaltvorrichtung 110 hindurch. Dabei weist ein in dem Lichtleiter 120 geleitetes Lichtsignal bei einem Eintritt in die Schaltvorrichtung 110 eine Eingangscharakteristik auf. Bei einem Austritt aus der Schaltvorrichtung 110 weist das Lichtsignal eine Ausgangscharakteristik auf. Optional kann der Lichtleiter 120 auch innerhalb der Schaltvorrichtung 110 zumindest eine Unterbrechung aufweisen, auch wenn dies in Fig. 1 nicht explizit dargestellt ist. Gemäß einem anderen Ausführungsbeispiel kann auch eine Mehrzahl von Lichtleitern 120 angeordnet sein.

Ferner weist die Schaltvorrichtung 110 des Steuersystems 100 ein Bedienelement 130 auf. Bei dem Bedienelement 130 handelt es sich beispielsweise um eine Taste, einen Schalter, eine Wipptaste, einen Wippschalter oder einen Schieber. Das Bedienelement 130 ist ausgebildet, um eine externe Betätigungskraft 131 in die Schaltvorrichtung 110 einzuleiten. Anders ausgedrückt ist das Bedienelement 130 ausgebildet, um eine durch einen Benutzer ausgeübte Betätigungskraft 131 in die Schaltvorrichtung 110 einzuleiten bzw. auf die Einstelleinrichtung 132 und gegebenenfalls den Lichtleiter 120 zu übertragen. Durch eine an der Schaltvorrichtung 110 bzw. dem Bedienelement 130 anliegenden Betätigungskraft 131 ist das Bedienelement 130 in unterschiedliche Stellungen bewegbar angeordnet. Dabei ist das Bedienelement 130 ausgebildet, um je nach Betätigungskraft 131 insbesondere zwischen einer Grundstellung, einer ersten Betätigungsstellung und einer zweiten Betätigungsstellung bewegbar zu sein.

Die Grundstellung des Bedienelements 130 entspricht hierbei einer Abwesenheit der Betätigungskraft 131 bzw. einem Ruhezustand des Bedienelements 130. Die erste Betätigungsstellung des Bedienelements 130 repräsentiert beispielsweise eine erste Stufe einer Bewegung bzw. Betätigungsbewegung des Bedienelements 130 bei anliegender Betätigungskraft 131. Die zweite Betätigungsstellung des Bedienelements 130 repräsentiert insbesondere eine zweite Stufe der Betätigungsbewegung des Bedienelements 130 bzw. beispielsweise eine Anschlagposition des Bedienelements 130 in der Schaltvorrichtung 110 bei anliegender Betätigungskraft 131. Gemäß einem anderen Ausführungsbeispiel kann das Bedienelement 130 zwischen mehr als drei Stellungen bewegbar sein.

Das Bedienelement 130 weist gemäß dem in Fig. 1 dargestellten Ausführungsbeispiel der vorliegenden Erfindung eine Einstelleinrichtung 132 auf. Dabei ist die Einstelleinrichtung 132 mechanisch mit dem Bedienelement 130 gekoppelt oder verbunden. Die Einstelleinrichtung 132 ist ausgebildet, um eine Ausgangscharakteristik eines in dem Lichtleiter 120 durch die Schaltvorrichtung 110 hindurch geleiteten Lichtsignals einzustellen. Genau gesagt ist die Einstelleinrichtung 132 ausgebildet, um die Ausgangscharakteristik abhängig von einer Stellung des Bedienelements 130 auf einen von mehreren unterschiedlichen Werten einzustellen.

Hierbei ist die Einstelleinrichtung 132 ausgebildet, um in der Grundstellung des Bedienelements 130 die Ausgangscharakteristik des Lichtsignals auf einen ersten Wert einzustellen. Ferner ist die Einstelleinrichtung 132 ausgebildet, um in der ersten Betätigungsstellung des Bedienelements 130 die Ausgangscharakteristik des Lichtsignals auf einen zweiten Wert einzustellen. Auch ist die Einstelleinrichtung 132 ausgebildet, um in der zweiten Betätigungsstellung des Bedienelements 130 die Ausgangscharakteristik des Lichtsignals auf einen dritten Wert einzustellen. Dabei sind der erste Wert, der zweite Wert und der dritte Wert voneinander unterschiedlich.

Gemäß einem Ausführungsbeispiel repräsentieren die Eingangscharakteristik und die Ausgangscharakteristik des Lichtsignals eine Lichtintensität des Lichtsignals. Insbesondere repräsentieren die Eingangscharakteristik und die Ausgangscharakteristik des Lichtsignals einen Lichtstrom, eine Beleuchtungsstärke, eine spezifische Lichtausstrahlung, eine Leuchtdichte, eine Lichtstärke, einen Lichtfluss, eine Lichtmenge, eine Belichtung oder eine Lichtausbeute des Lichtsignals. Alternativ repräsentieren die Eingangscharakteristik und die Ausgangscharakteristik des Lichtsignals eine Polarisationseigenschaft oder eine Farbe des Lichtsignals. Gemäß einem Ausführungsbeispiel ist der erste Wert der Ausgangscharakteristik ein maximaler Wert oder Pegel einer Lichtintensität des optischen Signals und ist der dritte Wert der Ausgangscharakteristik ein minimaler Wert oder Pegel einer Lichtintensität des optischen Signals.

Das Steuersystem weist ferner ein Steuergerät 140 auf. Das Steuergerät 140 ist mittels des Lichtleiters 120 datenübertragungsfähig mit der Schaltvorrichtung 110 verbunden. Der Lichtschalter 120 ist hierbei schleifenförmig ausgeführt, um eine datenübertragungsfähige Verbindung zwischen dem Steuergerät 140 und der Schaltvorrichtung 110 herzustellen.

Das Steuergerät 140 weist eine Einkopplungseinrichtung 142 und eine Erfassungseinrichtung 144 auf. Dabei ist die Einkopplungseinrichtung 142 ausgebildet, um das Lichtsignal mit der Eingangscharakteristik in den Lichtleiter 120 einzukoppeln. Die Einkopplungseinrichtung 142 weist eine Lichtquelle auf, die beispielsweise als eine Leuchtdiode ausgeführt ist. Die Erfassungseinrichtung 144 ist ausgebildet, um das Lichtsignal bzw. die Ausgangscharakteristik des Lichtsignals aus dem Lichtleiter 120 zu erfassen. Dabei ist die Erfassungseinrichtung 144 beispielsweise als ein Fototransistor ausgeführt.

Das Steuergerät 140 ist ausgebildet, um in Abhängigkeit von einem Wert der mittels der Erfassungseinrichtung 144 erfassten Ausgangscharakteristik des Lichtsignals ein Steuersignal 150 zu erzeugen. Dabei ist das Steuergerät 140 insbesondere ausgebildet, um je nach einem vorliegenden Wert der Ausgangscharakteristik ein unterschiedliches Steuersignal 150 zu erzeugen. Auch ist das Steuergerät 140 ausgebildet, um das Steuersignal 150 an eine Schnittstelle zu einer Vorrichtung auszugeben bzw. bereitzustellen.

Beispielsweise kann das Steuergerät 140 ausgebildet sein, um ein erstes Steuersignal 150 zu erzeugen oder ein Erzeugen eines Steuersignals 150 zu unterbrechen, wenn eine Ausgangscharakteristik mit dem ersten Wert erfasst wird, wobei das Bedienelement 130 in der Ruhestellung angeordnet ist. Wenn eine Ausgangscharakteristik mit dem zweiten Wert oder dem dritten Wert erfasst wird, wobei das Bedienelement 130 in der ersten Betätigungsstellung oder der zweiten Betätigungsstellung angeordnet ist, kann das Steuergerät 140 ausgebildet sein, um ein zweites Steuersignal 150 oder ein drittes Steuersignal 150 zu erzeugen.

Gemäß einem Ausführungsbeispiel ist das Steuergerät 140 ausgebildet, um das Steuersignal 150 an eine Schnittstelle zu einer Motorsteuervorrichtung und an eine Schnittstelle zu einer Getriebesteuervorrichtung auszugeben. Hierbei ist das Steuergerät 140 ausgebildet, um ansprechend auf den zweiten Wert der Ausgangscharakteristik des Lichtsignals ein erstes Steuersignal 150 zu erzeugen, das ein Motorstartsignal repräsentiert, und ansprechend auf den dritten Wert der Ausgangscharakteristik des Lichtsignals ein zweites Steuersignal 150 zu erzeugen, das ein Entriegelungssignal zum Lösen einer Getriebeverriegelung und/oder freigeben eines Wählhebels repräsentiert. Beispielsweise kann somit auch ein Fahrzeugstart oder Motorstart durch einen zweistufigen P-Schalter an einem Wählhebel eines Fahrzeugs realisiert werden. Zum Erzeugen des ersten Steuersignals 150 kann das Steuergerät hierbei 140 ausgebildet sein, um zu überprüfen, ob die erste Betätigungsstellung des Bedienelements 130 der Schaltvorrichtung 110 eine definierte Zeitdauer anliegt, beispielsweise mindestens eine halbe Sekunde, um einen Motorstart zu bewirken. Insbesondere mit einer Entriegelungstaste bzw. Unlock-Taste an einem Wählhebel eines Fahrzeugs lässt sich somit auch ein Fahrzeugstart funktionsmäßig verknüpfen. Wird die Schaltvorrichtung 110 für eine bestimmte Zeitdauer, z. B. eine Sekunde, in der ersten Betätigungsstellung betätigt, so kann bewirkt werden, das ein Motor des Fahrzeugs gestartet wird. Wenn die Schaltvorrichtung 110 in die zweite Betätigungsstellung versetzt wird, kann eine Getriebeverriegelung gelöst werden und einen Wechsel in einen anderen Gang bzw. eine andere Fahrstufe ermöglichen.

Gemäß einem Ausführungsbeispiel ist das Steuergerät 140 ausgebildet, um das Steuersignal 150 an eine Schnittstelle zu einer Getriebesteuervorrichtung auszugeben. Hierbei ist das Steuergerät 140 ausgebildet, um ansprechend auf den zweiten Wert der Ausgangscharakteristik des Lichtsignals ein erstes Steuersignal 150 zu erzeugen, das ein Vorwahlsignal zum Vorwählen einer Getriebestufe bzw. eines Ganges repräsentiert, und ansprechend auf den dritten Wert der Ausgangscharakteristik des Lichtsignals ein zweites Steuersignal 150 zu erzeugen, das ein Schaltsignal zum Einstellen einer Getriebestufe bzw. Einlegen eines Ganges repräsentiert. Eine Anwendung eines mehrstufigen Tasters als Schaltvorrichtung 110 im Fahrzeugbereich kann beispielsweise eine zweistufige Wipptaste für eine Schaltung in der sogenannten manuellen Gasse sein. Somit kann eine Vorsteuerung von Getrieben bzw. eine Gangvorwahl durch einen zweistufigen Schalter in der manuellen Gasse realisiert werden. Hinsichtlich eines Heraufschaltens (M+) und eines Herunterschaltens (M-) in der manuellen Gasse kann durch die erste Betätigungsstellung der Schaltvorrichtung 110 signalisiert werden, dass als die nächste manuelle Gangwahl ein Hochschalten oder ein Herunterschalten beabsichtigt ist. Aufgrund der zweiten Betätigungsstellung kann der tatsächliche Schaltvorgang ausgeführt werden.

Fig. 2A zeigt eine Teilschnittdarstellung einer Schaltvorrichtung 110 gemäß einem Ausführungsbeispiel der vorliegenden Erfindung. Bei der Schaltvorrichtung 110 kann es sich um die Schaltvorrichtung aus Fig. 1 handeln. Die Schaltvorrichtung 110 weist den Lichtleiter 120, das Bedienelement 130 und die Einstelleinrichtung 132 auf. In Fig. 2A sind ferner ein Gehäuse 212 der Schaltvorrichtung 110, ein Lichtsignal 222 in dem Lichtleiter 120, ein Druckabschnitt 232 der Einstelleinrichtung 132, eine Federeinrichtung 260 der Schaltvorrichtung 110 und eine Betätigungsachse A bzw. Bewegungsachse des Bedienelements 130 gezeigt. Hierbei ist die Schaltvorrichtung 110 in Fig. 2A in einer Grundstellung des Bedienelements 130 dargestellt.

In dem Gehäuse 212 sind ein Teilabschnitt des Lichtleiters 120, ein von der Stellung des Bedienelements 130 abhängiger Teilabschnitt des Bedienelements 130, die Einstelleinrichtung 132 und die Federeinrichtung 260 angeordnet.

Gemäß dem in Fig. 2A dargestellten Ausführungsbeispiel der vorliegenden Erfindung ist der Lichtleiter 120 als ein durchgehender Lichtleiter ausgeformt. In dem Lichtleiter 120 breitet sich das Lichtsignal 222 entlang einem Lichtweg aus, wie es durch einen Pfeil in der Figur symbolisch veranschaulicht ist. Der Lichtleiter 120 erstreckt sich hierbei in der in Fig. 2A gezeigten Grundstellung des Bedienelements 130 linear durch die Schaltvorrichtung 110 hindurch. Dabei weist der Lichtschalter 110 innerhalb des Gehäuses 212 eine Haupterstreckungsachse bzw. Längserstreckungsachse auf, die in der in Fig. 2A gezeigten Grundstellung des Bedienelements 130 dem Lichtweg des Lichtsignals 222 entspricht.

Das Bedienelement 130 ist als eine Taste ausgeformt. In der in Fig. 2A dargestellten Grundstellung erstreckt sich ein maximaler Teilabschnitt des Bedienelements 130 aus dem Gehäuse 212 heraus. Bei Vorliegen der Betätigungskraft 131 ist das Bedienelement 130 entlang der Betätigungsachse A zwischen den unterschiedlichen Stellungen bewegbar. Dabei erstreckt sich die Betätigungsachse A gemäß dem in Fig. 2A dargestellten Ausführungsbeispiel der vorliegenden Erfindung innerhalb von Fertigungstoleranzen normal oder quer zu der Längserstreckungsachse des Lichtleiters 120.

Die Einstelleinrichtung 132 weist gemäß dem in Fig. 2A dargestellten Ausführungsbeispiel der vorliegenden Erfindung einen Druckabschnitt 232 oder ein Druckelement auf. Dabei weist der Druckabschnitt 232 genau gesagt ein stabförmiges Schnittprofil mit einer Haupterstreckungsachse auf. Die Haupterstreckungsachse des Druckabschnittes 232 erstreckt sich hierbei entlang der Betätigungsachse A des Bedienelements 130. Der Druckabschnitt 232 ist ausgebildet, um abhängig von der jeweiligen Stellung des Bedienelements 130 einen Krümmungsradius des Lichtleiters 120 zu verändern.

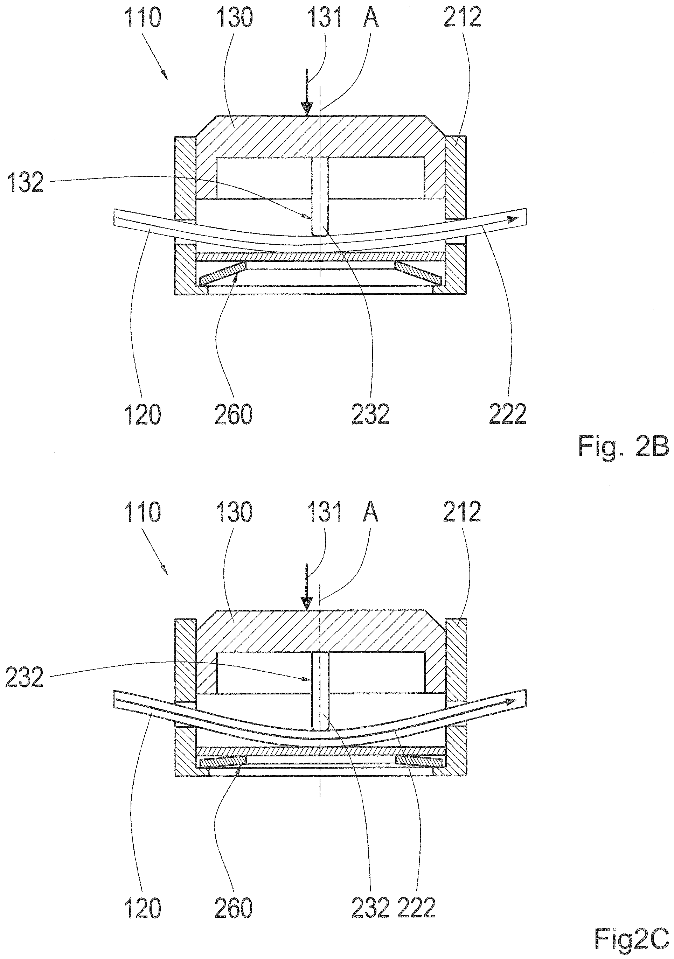

Hierbei ist die Einstelleinrichtung 132 mit dem Druckabschnitt 232 insbesondere ausgebildet, um in der Grundstellung des Bedienelements 130 von dem Lichtschalter 120 beabstandet angeordnet zu sein und in einer von der Grundstellung abweichenden Stellung des Bedienelements 130 den Lichtleiter 120 zu verbiegen. Von der Grundstellung abweichende Stellungen des Bedienelements 130 sind beispielsweise in den Figuren 2B und 2C dargestellt.

Die Federeinrichtung 260 ist ausgebildet, um eine der Betätigungskraft 131 entgegengerichtete Federkraft an das Bedienelement 130 anzulegen. Gemäß dem in Fig. 2A dargestellten Ausführungsbeispiel der vorliegenden Erfindung ist die Federeinrichtung 260 als eine Tellerfeder ausgeführt. Insbesondere ist die Federeinrichtung 260 ausgebildet, um die mehrstufige Bewegung des Bedienelements 130 zwischen der Grundstellung, der ersten Betätigungsstellung und der zweiten Betätigungsstellung zu regulieren. Der Lichtschalter 120 ist hierbei zwischen der Einstelleinrichtung 132 und der Federeinrichtung 260 angeordnet. Gemäß einem anderen Ausführungsbeispiel kann die Schaltvorrichtung 110 eine Mehrzahl von Federeinrichtungen aufweisen.

In der in Fig. 2A gezeigten Grundstellung erstreckt sich ein Teilabschnitt des Bedienelements 130 maximal weit aus dem Gehäuse 212 heraus, ist die Einstelleinrichtung 132 mit dem Druckabschnitt 232 von dem Lichtleiter 120 beabstandet angeordnet, erstreckt sich der Lichtleiter 120 innerhalb von Montagetoleranzen linear durch die Schaltvorrichtung 110 hindurch und sind das Bedienelement 130 und die Federeinrichtung 260 kraftmäßig voneinander entkoppelt.

Fig. 2B zeigt die Schaltvorrichtung 110 aus Fig. 2A in einer ersten Betätigungsstellung des Bedienelements 130. In der in Fig. 2B gezeigten ersten Betätigungsstellung erstreckt sich ein bezüglich des maximalen Teilabschnitts reduzierter Teilabschnitt des Bedienelements 130 aus dem Gehäuse 212 heraus, ist die Einstelleinrichtung 132 mit dem Druckabschnitt 232 in Anlage gegen den Lichtleiter 120 angeordnet und biegt den Lichtleiter 120 in Anlage gegen die Federeinrichtung 260 durch. Dadurch weist der Lichtleiter 120 einen ersten Krümmungsradius innerhalb des Gehäuses 212 auf. Die Federeinrichtung 260 befindet sich weiterhin in einem unkomprimierten Zustand.

Fig. 2C zeigt die Schaltvorrichtung 110 aus Fig. 2A bzw. Fig. 2B in einer zweiten Betätigungsstellung des Bedienelements 130. In der in Fig. 2C gezeigten zweiten Betätigungsstellung erstreckt sich ein minimaler Teilabschnitt des Bedienelements 130 aus dem Gehäuse 212 heraus. Die Einstelleinrichtung 132 ist mit dem Druckabschnitt 232 in Anlage gegen den Lichtleiter 120 angeordnet und biegt den Lichtleiter 120 in Anlage gegen die Federeinrichtung 260 durch. Die Betätigungskraft 131 wird über die Einstelleinrichtung 132 und den Lichtleiter 120 auf die Federeinrichtung 260 übertragen. Die Betätigungskraft 131 weist eine Größe auf, die eine Einfederung der Federeinrichtung 260 bewirkt. Dadurch wird der Lichtleiter 120 im Vergleich zu dem in Fig. 2B gezeigten Zustand stärker durchgebogen. Somit weist der Lichtleiter 120 in dem in Fig. 2C gezeigten Zustand einen zweiten Krümmungsradius innerhalb des Gehäuses 212 auf, der kleiner als der erste Krümmungsradius ist. Die Federeinrichtung 260 befindet sich in einem durch das Bedienelement 130 und die Einstelleinrichtung 132 komprimierten Zustand.

Unter Bezugnahme auf die Figuren 2A bis 2C ist zu bemerken, dass die Schaltvorrichtung 110 als ein Taster bzw. Stufenschalter mit Drucksensorik durch Deformation des Lichtleiters 120 ähnlich faseroptischen Drucksensoren ausgeführt ist. Die Transmission für das Lichtsignal 222 in dem Lichtleiter 120 verschlechtert sich, wenn der Lichtleiter 120 bei Betätigung der Schaltvorrichtung 110 bzw. des Bedienelements 130 durch die Einstelleinrichtung 132 durchgebogen bzw. gekrümmt wird. Eine Druckwirkung bzw. Biegewirkung wird durch einen elastischen Mechanismus, hier eine untergelegte Federeinrichtung 260 in Gestalt einer Tellerfeder, in zwei Stufen verändert. Wenn das Bedienelement 130 bzw. die Einstelleinrichtung 132 die Federeinrichtung 260 erreicht, nimmt der Druck bzw. die Federkraft zu. Gemäß einem Ausführungsbeispiel können durch Schichten bzw. Stapeln mehrerer Federeinrichtungen 260, beispielsweise Tellerfedern, mit ansteigender Federsteifigkeit auch mehrstufige Taster realisiert werden.

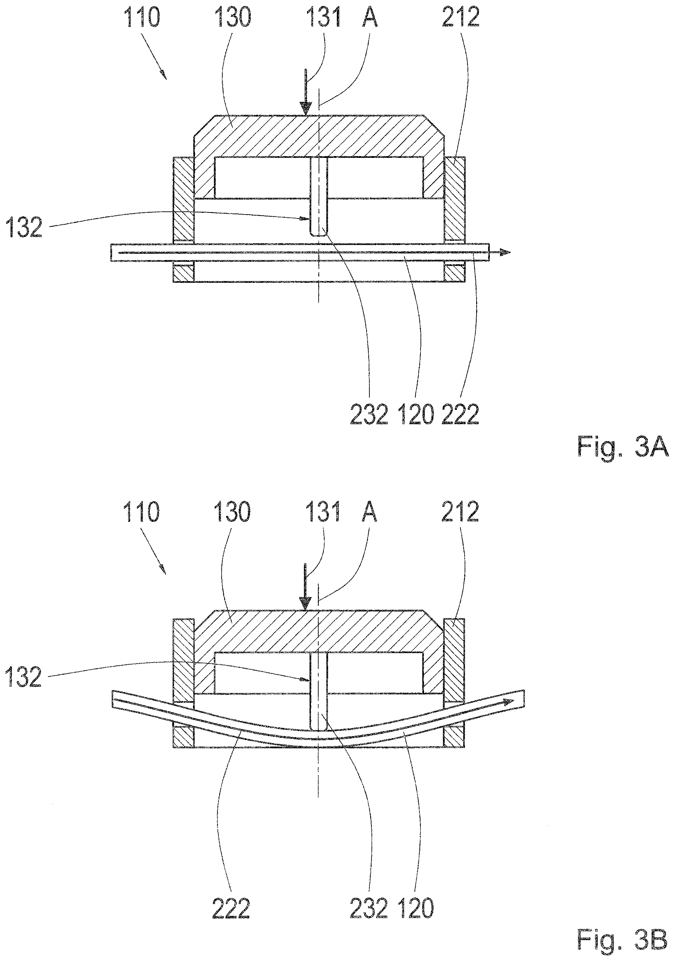

Fig. 3A zeigt eine Teilschnittdarstellung einer Schaltvorrichtung 110 gemäß einem nicht zur Erfindung gehörenden beispielhaften Ausführungsbeispiel Hierbei entsprechen die Schaltvorrichtung 110 und die Darstellung in Fig. 3A der Schaltvorrichtung sowie der Darstellung aus Fig. 2A mit der Ausnahme, dass die Schaltvorrichtung 110 in Fig. 3A ohne Federeinrichtung gezeigt ist bzw. keine Federeinrichtung aufweist. In Fig. 3A ist die Schaltvorrichtung 110 in der Grundstellung des Bedienelements 130 gezeigt.

Fig. 3B zeigt die in Fig. 3A dargestellte Schaltvorrichtung 110 in einer Betätigungsstellung des Bedienelements 130. Hierbei endet die Darstellung in Fig. 3B insbesondere der Darstellung aus Fig. 2B oder Fig. 2C.

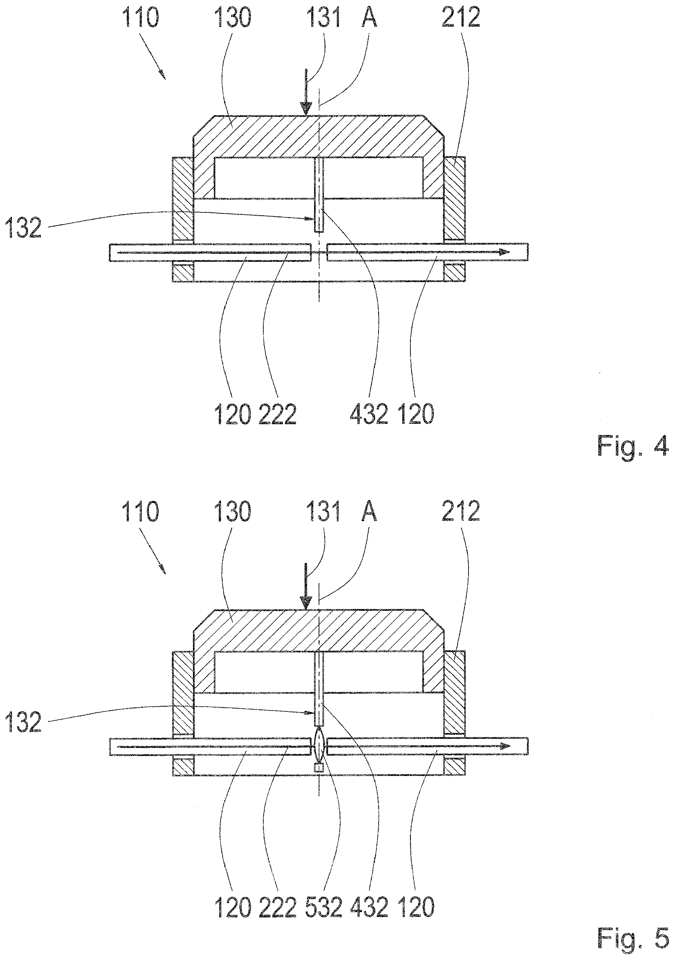

Fig. 4 zeigt eine Teilschnittdarstellung einer Schaltvorrichtung 110 gemäß einem nicht zur Erfindung gehörenden beispielhaften Ausführungsbeispiel. Hierbei entsprechen die Schaltvorrichtung 110 und die Darstellung in Fig. 4 der Schaltvorrichtung sowie der Darstellung aus Fig. 3A mit der Ausnahme, dass in Fig. 4 der Lichtleiter 120 innerhalb der Schaltvorrichtung 110 unterbrochen ist und dass die Schaltvorrichtung 110 als Einstelleinrichtung 132 einen Unterbrechungsabschnitt 432 bzw. Dämpferabschnitt aufweist. In Fig. 4 ist die Schaltvorrichtung 110 in der Grundstellung des Bedienelements 130 gezeigt.

Der unterbrochene Lichtleiter 120 weist einen luftgefüllten Zwischenraum zwischen zwei Teilabschnitten des Lichtleiters 120 auf. Die beiden Teilabschnitte des Lichtleiters 120 erstrecken sich entlang einer gemeinsamen Längserstreckungsachse des Lichtleiters 120 innerhalb des Gehäuses 212 der Schaltvorrichtung 110. Das Lichtsignal 222 bzw. der Lichtweg verläuft in der Grundstellung des Bedienelements 130 aus einem eingangsseitigen Teilabschnitt des Lichtleiters 120 durch den Zwischenraum hindurch in einen ausgangsseitigen Teilabschnitt des Lichtleiters 120.

Die Einstelleinrichtung 132 ist aus einem optisch undurchlässigen Material ausgeformt. Die Einstelleinrichtung 132 mit dem Unterbrechungsabschnitt 432 ist ausgebildet, um abhängig von einer Stellung des Bedienelements 130 das Lichtsignal 222 in dem Lichtleiter 120 mindestens teilweise durchzulassen oder mindestens teilweise zu unterbrechen. In der in Fig. 4 dargestellten Grundstellung ist die Einstelleinrichtung 132 mit dem Unterbrechungsabschnitt 432 ausgebildet, um das Lichtsignal 222 in dem Lichtleiter 120 durchzulassen. Dabei ist die Einstelleinrichtung 132 mit dem Unterbrechungsabschnitt 432 außerhalb des Zwischenraums zwischen den zwei Teilabschnitten des Lichtleiters 120 angeordnet. In einer Betätigungsstellung kann der Unterbrechungsabschnitt 432 ausgebildet sein, um das Lichtsignal 222 zumindest teilweise zu unterbrechen. Dabei kann sich die Einstelleinrichtung 132 mit dem Unterbrechungsabschnitt 432 in einer Betätigungsstellung des Bedienelements 130 in den Zwischenraum zwischen den beiden Teilabschnitten des Lichtleiters 120 hinein erstrecken. Beispielsweise kann sich der Unterbrechungsabschnitt 432 in der Grundstellung außerhalb des Zwischenraums befinden, in der ersten Betätigungsstellung den Zwischenraum teilweise, beispielsweise zur Hälfte ausfüllen, und in der zweiten Betätigungsstellung den Zwischenraum vollständig ausfüllen.

Fig. 5 zeigt eine Teilschnittdarstellung einer Schaltvorrichtung 110 gemäß einem nicht zur Erfindung gehörenden beispielhaften Ausführungsbeispiel. Hierbei entsprechen die Schaltvorrichtung 110 und die Darstellung in Fig. 5 der Schaltvorrichtung sowie der Darstellung aus Fig. 4 mit der Ausnahme, dass in Fig. 5 die Schaltvorrichtung 110 eine Einstelleinrichtung 132 mit einem Unterbrechungsabschnitt 432 bzw. Dämpferabschnitt mit einem zusätzlichen optischen Element 532 aufweist. In Fig. 5 ist die Schaltvorrichtung 110 in der Grundstellung des Bedienelements 130 gezeigt.

Die Einstelleinrichtung 132 weist hierbei den Unterbrechungsabschnitt 432 und das optische Element 532 auf. In der in Fig. 5 dargestellten Grundstellung ist das optische Element 532 der Einstelleinrichtung 132 in dem Zwischenraum zwischen den beiden Teilabschnitten des Lichtleiters 120 angeordnet. In der in Fig. 5 dargestellten Grundstellung ist die Einstelleinrichtung 132 ausgebildet, um das Lichtsignal 222 in dem Lichtleiter 120 zumindest teilweise durchzulassen. In einer Betätigungsstellung kann die Einstelleinrichtung 132 ausgebildet sein, um das Lichtsignal 222 mindestens teilweise zu unterbrechen. Dabei kann sich der Unterbrechungsabschnitt 432 der Einstelleinrichtung 132 in einer Betätigungsstellung des Bedienelements 130 in den Zwischenraum zwischen den beiden Teilabschnitten des Lichtleiters 120 hinein erstrecken.

Unter Bezugnahme auf die Figuren 4 und 5 ist anzumerken, dass gemäß einem nicht zur Erfindung gehörenden beispielhaften Ausführungsbeispiel die Schaltvorrichtung 110 als ein Taster mit Unterbrechung des Lichtweges ausgeführt sein kann. Bei kleinem Durchmesser des Lichtleiters 120 ergibt sich für das Ausführungsbeispiel aus Fig. 4 ein nahezu digitales Schaltverhalten. Um einen Lichtverlust zu begrenzen, ist in Fig. 5 das optische Element 532 bzw. optische Zwischenglied angeordnet, um eine Reduzierung eines Lichtdurchgangs des optischen Signals 222 in einem betätigten Zustand bzw. einer Betätigungsstellung relativ zu dem Ruhezustand bzw. der Grundstellung zu vermindern.

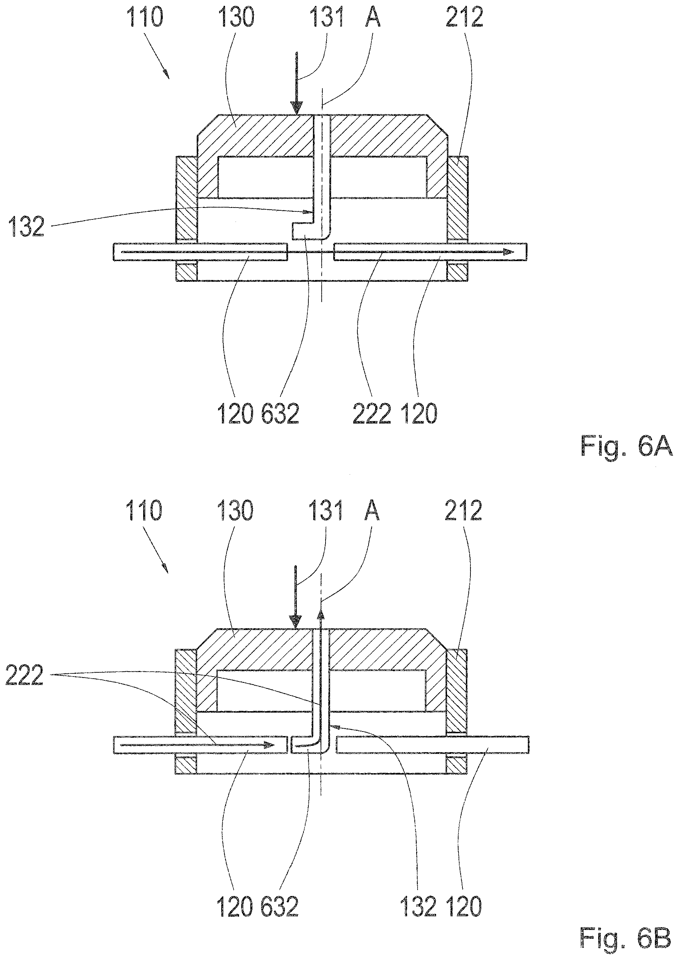

Fig. 6A zeigt eine Teilschnittdarstellung einer Schaltvorrichtung 110 gemäß einem nicht zur Erfindung gehörenden beispielhaften Ausführungsbeispiel. Hierbei entsprechen die Schaltvorrichtung 110 und die Darstellung in Fig. 6A der Schaltvorrichtung sowie der Darstellung aus Fig. 3A mit der Ausnahme, dass in Fig. 6A der Lichtleiter 120 innerhalb der Schaltvorrichtung 110 unterbrochen ist und dass die Schaltvorrichtung 110 als Einstelleinrichtung 132 einen weiteren Lichtleiter 632 aufweist. In Fig. 6A ist die Schaltvorrichtung 110 in der Grundstellung des Bedienelements 130 gezeigt.

Der unterbrochene Lichtleiter 120 weist einen luftgefüllten Zwischenraum zwischen zwei Teilabschnitten des Lichtleiters 120 auf. Die beiden Teilabschnitte des Lichtleiters 120 erstrecken sich entlang einer gemeinsamen Längserstreckungsachse des Lichtleiters 120 innerhalb des Gehäuses 212 der Schaltvorrichtung 110. Das Lichtsignal 222 bzw. der Lichtweg verläuft in der Grundstellung des Bedienelements 130 aus einem eingangsseitigen Teilabschnitt des Lichtleiters 120 durch den Zwischenraum hindurch in einen ausgangsseitigen Teilabschnitt des Lichtleiters 120.

Der weitere Lichtleiter 632 erstreckt sich von dem Bedienelement 130 in Richtung zu dem Lichtleiter 120. Der weitere Lichtleiter 632 weist einen ersten Abschnitt, einen Knickabschnitt und einem zweiten Abschnitt auf. Der erste Abschnitt erstreckt sich entlang der Betätigungsachse A der Schaltvorrichtung 110. Der zweite Abschnitt erstreckt sich entlang einer gemeinsamen Längserstreckungsachse des Lichtleiters 120 in Richtung zu dem eingangsseitigen Teilabschnitt des Lichtleiters 120 hin. Der Knickabschnitt des weiteren Lichtleiters 632 ist zwischen dem ersten Abschnitt und dem zweiten Abschnitt angeordnet.

Die Einstelleinrichtung 132 mit dem weiteren Lichtleiter 632 ist ausgebildet, um abhängig von einer Stellung des Bedienelements 130 das Lichtsignal 222 in dem Lichtleiter 120 mindestens teilweise durchzulassen und zusätzlich oder alternativ mindestens teilweise zu dem Bedienelement 130 umzuleiten. In der in Fig. 6A dargestellten Grundstellung ist die Einstelleinrichtung 132 mit dem weiteren Lichtleiter 632 ausgebildet, um das Lichtsignal 222 in dem Lichtleiter 120 durchzulassen. Dabei ist die Einstelleinrichtung 132 mit dem weiteren Lichtleiter 632 außerhalb des Zwischenraums zwischen den zwei Teilabschnitten des Lichtleiters 120 angeordnet.

Fig. 6B zeigt die Schaltvorrichtung 110 aus Fig. 6A in einer Betätigungsstellung des Bedienelements 130. Hierbei ist der zweite Abschnitt des weiteren Lichtleiter 632 der Einstelleinrichtung 132 vollständig in dem Zwischenraum zwischen den zwei Teilabschnitten des Lichtleiters 120 angeordnet. Das Lichtsignal 222 tritt aus dem eingangsseitigen Teilabschnitt des Lichtleiters 120 aus und tritt in den weiteren Lichtleiter 632 ein. Dabei verläuft ein Lichtweg zu dem Bedienelement 130 hin. In der in Fig. 6B dargestellten Betätigungsstellung ist die Einstelleinrichtung 132 mit dem weiteren Lichtleiter 632 ausgebildet, um das Lichtsignal 222 vollständig zu dem Bedienelement 130 umzuleiten. Dabei kann sich die Einstelleinrichtung 132 mit dem weiteren Lichtleiter 632 in einer Betätigungsstellung des Bedienelements 130 in den Zwischenraum zwischen den beiden Teilabschnitten des Lichtleiters 120 hinein erstrecken.

Gemäß einem weiteren nicht zur Erfindung gehörenden beispielhaften Ausführungsbeispiel kann der zweite Abschnitt des weiteren Lichtleiters 632 in einer weiteren Betätigungsstellung nur teilweise in dem Zwischenraum angeordnet sein, sodass ein erster Anteil des Lichtsignals 222 von dem weiteren Lichtleiter 632 umgeleitet wird und ein zweiter Anteil des Lichtsignals 222 den ausgangsseitigen Teilabschnitt des Lichtleiters 120 passieren kann.

Unter Bezugnahme auf die Figuren 6A und 6B ist anzumerken, dass in der dargestellten Schaltvorrichtung 110 eine Umleitung des Lichtweges bzw. des Lichtsignals 222 erfolgt, wenn eine Betätigungsstellung des Bedienelement 130 vorliegt. Es wird bei Betätigung der Taste der weitere Lichtleiter 632 in einen Strahlengang des Lichtsignals 222 gebracht. Bei großflächigen Schaltern mit Beleuchtung lässt sich somit eine Betätigungsstellung durch eine höhere Helligkeit einer Schaltersymbolik des Bedienelement 130 auch optisch signalisieren.

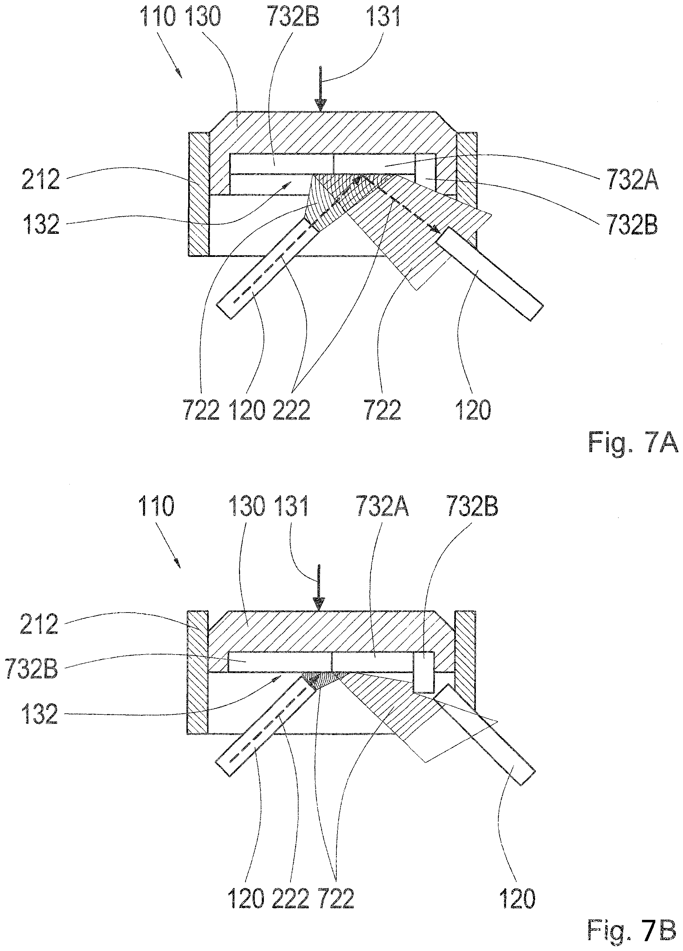

Fig. 7A zeigt eine Teilschnittdarstellung einer Schaltvorrichtung 110 gemäß einem nicht zur Erfindung gehörenden beispielhaften Ausführungsbeispiel. Hierbei entsprechen die Schaltvorrichtung 110 und die Darstellung in Fig. 7A der Schaltvorrichtung sowie der Darstellung aus Fig. 3A mit der Ausnahme, dass in Fig. 7A der Lichtleiter 120 innerhalb der Schaltvorrichtung 110 unterbrochen ist, wobei Teilabschnitte des Lichtleiters 120 relativ zueinander geneigte Längserstreckungsachsen aufweisen, und dass die Schaltvorrichtung 110 eine Einstelleinrichtung 132 mit beispielhaft einem Reflektor 732A und zwei Absorbern 732B aufweist. In Fig. 7A ist die Schaltvorrichtung 110 in der Grundstellung des Bedienelements 130 gezeigt.

Der unterbrochene Lichtleiter 120 weist einen luftgefüllten Zwischenraum zwischen zwei Teilabschnitten des Lichtleiters 120 auf. Die beiden Teilabschnitte des Lichtleiters 120 erstrecken sich entlang zueinander geneigter Längserstreckungsachsen innerhalb des Gehäuses 212 der Schaltvorrichtung 110. Die Einstelleinrichtung 132 mit dem Reflektor 732A und den Absorbern 732B ist an einer dem Lichtleiter 120 zugewandten Seite des Bedienelements 130 angeordnet. Der Reflektor 732A ist hierbei zwischen einem ersten Absorber 732B und einem zweiten Absorber 732B angeordnet. Dabei ist der Reflektor 732A als ein Spiegel bzw. aus einem optisch reflektierenden Material ausgeformt. Der Reflektor 732A ist ausgebildet, um das optische Signal 222 zu reflektieren. Die Absorber 732B weisen zum Beispiel eine mattschwarze Farbe auf. Dabei sind die Absorber 732B ausgebildet, um zumindest einen Anteil des optischen Signals 222 zu absorbieren.

Die Einstelleinrichtung 132 mit dem Reflektor 732A und den Absorbern 732B ist ausgebildet, um abhängig von einer Stellung des Bedienelements 130 das Lichtsignal 222 in dem Lichtleiter 120 mindestens teilweise durchzulassen oder mindestens teilweise zu dämpfen und zusätzlich oder alternativ zu unterbrechen. In der in Fig. 7A dargestellten Grundstellung ist die Einstelleinrichtung 132 mit dem Reflektor 732A und den Absorbern 732B ausgebildet, um das Lichtsignal 222 in dem Lichtleiter 120 durchzulassen. Dabei verläuft das Lichtsignal 222 bzw. der Lichtweg in der Grundstellung des Bedienelements 130 aus einem eingangsseitigen Teilabschnitt des Lichtleiters 120 in Gestalt eines Lichtkegels 722 durch den Zwischenraum hindurch zu dem Reflektor 732A und wird an dem Reflektor 732A in einen ausgangsseitigen Teilabschnitt des Lichtleiters 120 reflektiert.

Fig. 7B zeigt die Schaltvorrichtung 110 aus Fig. 7A in einer Betätigungsstellung des Bedienelements 130. In der in Fig. 7B dargestellten Betätigungsstellung ist die Einstelleinrichtung 132 mit dem Reflektor 732A und den Absorbern 732B ausgebildet, um das Lichtsignal 222 in dem Lichtleiter 120 mindestens teilweise zu dämpfen und zusätzlich oder alternativ zu unterbrechen. Dabei verläuft das Lichtsignal 222 bzw. der Lichtweg in der Betätigungsstellung des Bedienelements 130 aus einem eingangsseitigen Teilabschnitt des Lichtleiters 120 in Gestalt des Lichtkegels 722 durch den Zwischenraum hindurch zu dem ersten Absorber 732B und wird durch den ersten Absorber 732B zumindest teilweise absorbiert. Der zweite Absorber 732B ist angeordnet und ausgebildet, um einen zu dem ausgangsseitigen Teilabschnitt des Lichtleiters 120 reflektierten Anteil des Lichtsignals 222 von dem ausgangsseitigen Teilabschnitt des Lichtleiters 120 abzuschirmen.

Unter Bezugnahme auf Fig. 7A und Fig. 7B ist anzumerken, dass die Schaltvorrichtung 110 als ein Taster mit stellungsabhängiger Reflexion oder Absorption des Lichtsignals 222 ausgeführt ist. Hierbei wird der aus dem eingangsseitigen Teilabschnitt des Lichtleiters 120 austretende Lichtkegel 722 bzw. Lichtstrahl an einer Unterseite des Bedienelements 130 in den ausgangsseitigen Teilabschnitt des Lichtleiters 120 reflektiert. In der Grundstellung strahlt der eingangsseitige Teilabschnitt des Lichtleiters als 120 auf den Reflektor 732A und somit auf eine helle bzw. spiegelnde Fläche. Wird das Bedienelement 130 gedrückt und damit in eine Betätigungsstellung versetzt, verschiebt sich der Reflektor 732A bzw. die Reflexionsfläche bezüglich des eingangsseitigen Teilabschnitts des Lichtleiters 120. Ein wachsender Teil des Lichtsignals 222 wird auf den Absorber 732B bzw. eine schwarze Fläche gestrahlt, die das Lichtsignal 222 absorbiert. Der zweite Absorber 732B bzw. eine Blende deckt beispielsweise in einer vollständig betätigten Stellung des Bedienelements 130 den ausgangsseitigen Teilabschnitt des Lichtleiters 120 ab. Auf diese Art wird ein relativ analoges Ansprechverhalten der Schaltvorrichtung 110 erhalten, woraus auch darauf geschlossen werden kann, wie weit das Bedienelement 130 gedrückt ist. Gemäß einem Ausführungsbeispiel kann ein optisches Element vor einem Eintritt des Lichtsignals 222 in den ausgangsseitigen Teilabschnitt des Lichtleiters 120 angeordnet sein.

Unter Bezugnahme auf die Figuren 1 bis 7B werden Ausführungsbeispiele der vorliegenden Erfindung, Varianten, nicht zur Erfindung gehörende, beispielhafte Ausführungsbeispiele und weitere Aspekte im Folgenden zusammenfassend und mit anderen Worten erläutert.

Gemäß einem Ausführungsbeispiel kann die Einstelleinrichtung 132 der Schaltvorrichtung 110 zumindest einen Polfilter aufweisen. Eine Schwächung des Lichtstromes des Lichtsignals 222 kann hierbei durch polarisierende Filter erreicht werden. Gemäß einem Ausführungsbeispiel kann die Schaltvorrichtung 110 als ein Schalter ausgeführt sein.

Gemäß Ausführungsbeispielen der vorliegenden Erfindung kann eine Erfassung von Taster- und Schaltersignalen in einem Wählhebel eines Fahrzeugs mit Hilfe von Lichtleitern erfolgen, wobei die Einstelleinrichtung 132, 232, 432, 532, 632, 732A, 732B als ein Trennmechanismus fungieren kann, der ausgebildet ist, um den Lichtstrom des Lichtsignals 222 abhängig von einer Stellung des Bedienelement 130 zu unterbrechen oder zu dämpfen. Hierbei ist auch eine Schaltvorrichtung 110 mit mehrstufiger Ausführung eines Schalters und zusätzlich oder alternativ mit geschlossener bzw. einteiliger Lichtleiter-Schleife oder mit offener bzw. zweiteiliger Lichtleiter-Schleife vorgesehen. Dabei kann der Lichtstrom des Lichtsignals 222 über Reflexion an verschieden absorbierenden Medien durch die Schalterbetätigung geschwächt werden, kann der Lichtstrom des Lichtsignals 222 über polarisierende Filter durch die Schalterbetätigung geschwächt werden und kann zusätzlich oder alternativ ein optisches Zwischenglied Transmissionsverluste im offenen Lichtleiter 120 reduzieren.

Gemäß einem Ausführungsbeispiel kann eine Schaltung des Lichtstroms des Lichtsignals 222 bzw. der Einkopplungseinrichtung 142 bzw. einer Lichtquelle erreicht werden, wobei ein dunkler Zustand so gewählt sein kann, dass bei mehreren Schaltzuständen mit dem dunklen Zustand ein ausfallsicherer Zustand bzw. failsafe-Zustand signalisiert wird. Es kann der Lichtstrom durch den zumindest einen Lichtleiter 120 geschaltet werden. So wird der Lichtstrom für eine Entriegelungstaste bzw. Unlock-Taste an einem Wählhebel eines Fahrzeugs beispielsweise dann eingeschaltet, wenn ein Fahrer das Bremspedal betätigt. Die Schaltung des Lichtstroms kann beispielsweise auch durch ein Getriebe des Fahrzeugs vorgenommen werden. Dies kann als zweite Sicherung gegen Fehlfunktionen des Wählhebels bei der Fahrstufenausgabe genutzt werden.

Die beschriebenen und in den Figuren gezeigten Ausführungsbeispiele sind nur beispielhaft gewählt. Unterschiedliche Ausführungsbeispiele können vollständig oder in Bezug auf einzelne Merkmale miteinander kombiniert werden. Auch kann ein Ausführungsbeispiel durch Merkmale eines weiteren Ausführungsbeispiels ergänzt werden, solange der Schutzbereich der Ansprüche nicht verlassen wird, da die Erfindung durch die angehängten Ansprüche definiert wird.

Umfasst ein Ausführungsbeispiel eine "und/oder" Verknüpfung zwischen einem ersten Merkmal und einem zweiten Merkmal, so kann dies so gelesen werden, dass das Ausführungsbeispiel gemäß einer Ausführungsform sowohl das erste Merkmal als auch das zweite Merkmal und gemäß einer weiteren Ausführungsform entweder nur das erste Merkmal oder nur das zweite Merkmal aufweist.

### Bezugszeichen

- 100: Steuersystem
- 110: Schaltvorrichtung
- 120: Lichtleiter
- 130: Bedienelement
- 131: Betätigungskraft
- 132: Einstelleinrichtung
- 140: Steuergerät
- 142: Einkopplungseinrichtung bzw. Lichtquelle
- 144: Erfassungseinrichtung bzw. Fototransistor
- 150: Steuersignal
- 212: Gehäuse
- 222: Lichtsignal bzw. Lichtweg
- 232: Druckabschnitt
- 260: Federeinrichtung bzw. Tellerfeder bzw. elastisches Mittel
- A: Betätigungsachse bzw. Bewegungsachse
- 432: Unterbrechungsabschnitt
- 532: optisches Element
- 632: weiterer Lichtleiter
- 722: Lichtkegel
- 732A: Reflektor
- 732B: Absorber

## Patentansprüche

1. Schaltvorrichtung (110) für ein Steuersystem (100) für ein Fahrzeug, wobei die Schaltvorrichtung (110) folgende Merkmale aufweist:
zumindest einen Lichtleiter (120) zum Leiten eines Lichtsignals (222), wobei das Lichtsignal (222) bei einem Eintritt in die Schaltvorrichtung (110) eine Eingangscharakteristik aufweist und bei einem Austritt aus der Schaltvorrichtung (110) eine Ausgangscharakteristik aufweist; und
ein Bedienelement (130) zum Einleiten einer Betätigungskraft (131) in die Schaltvorrichtung (110), wobei das Bedienelement (130) aufgrund der Betätigungskraft (131) zwischen einer Grundstellung, einer ersten Betätigungsstellung und einer zweiten Betätigungsstellung bewegbar ist, wobei das Bedienelement (130) eine Einstelleinrichtung (132; 232; 432; 532; 632; 732A, 732B) zum Einstellen einer Charakteristik des Lichtsignals (222) aufweist, wobei die Einstelleinrichtung (132; 232; 432; 532; 632; 732A, 732B) ausgebildet ist, um in der Grundstellung des Bedienelements (130) die Ausgangscharakteristik des Lichtsignals (222) auf einen ersten Wert einzustellen, in der ersten Betätigungsstellung die Ausgangscharakteristik des Lichtsignals (222) auf einen zweiten Wert einzustellen und in der zweiten Betätigungsstellung die Ausgangscharakteristik des Lichtsignals (222) auf einen dritten Wert einzustellen, wobei der erste Wert, der zweite Wert und der dritte Wert voneinander unterschiedlich sind, **dadurch gekennzeichnet, dass** die Schaltvorrichtung (110) einen durchgehenden Lichtleiter als den zumindest einen Lichtleiter (120) und zumindest eine Federeinrichtung (260) zum Anleger einer der Betätigungskraft (131) entgegengerichteten Federkraft an das Bedienelement (130) aufweist, wobei die Federeinrichtung (260) ausgebildet ist, um eine mehrstufige Bewegung des Bedienelements (130) zwischen der Grundstellung, der ersten Betätigungsstellung und der zweiten Betätigungsstellung zu regulieren, wobei die Einstelleinrichtung (132) zumindest einen Druckabschnitt (232) aufweist, der ausgebildet ist, um abhängig von einer Stellung des Bedienelements (130) einen Krümmungsradius des zumindest einen Lichtleiters (120) zu verändern, wobei der Lichtleiter (120) zwischen dem zumindest einen Druckabschnitt (232) und der Federeinrichtung (260) angeordnet ist.

2. Schaltvorrichtung (110) gemäß Anspruch 1, **dadurch gekennzeichnet, dass** die Einstelleinrichtung (132) zumindest einen Dämpferabschnitt (432; 532; 732A, 732B) aufweist, der ausgebildet ist, um abhängig von einer Stellung des Bedienelements (130) das Lichtsignal (222) in dem zumindest einen Lichtleiter (120) mindestens teilweise durchzulassen und/oder mindestens teilweise zu dämpfen oder zu unterbrechen.

3. Schaltvorrichtung (110) gemäß einem der vorangegangenen Ansprüche, **dadurch gekennzeichnet, dass** die Einstelleinrichtung (132) zumindest einen weiteren Lichtleiter (632) aufweist, der ausgebildet ist, um abhängig von einer Stellung des Bedienelements (130) das Lichtsignal (222) in dem zumindest einen Lichtleiter (120) mindestens teilweise durchzulassen und/oder mindestens teilweise zu dem Bedienelement (130) umzuleiten.

4. Schaltvorrichtung (110) gemäß einem der vorangegangenen Ansprüche, **dadurch gekennzeichnet, dass** die Eingangscharakteristik und die Ausgangscharakteristik des Lichtsignals (222) eine Lichtintensität oder einen Lichtstrom repräsentieren.

5. Schaltvorrichtung (110) gemäß einem der vorangegangenen Ansprüche, **dadurch gekennzeichnet, dass** der erste Wert der Ausgangscharakteristik einen maximalen Wert repräsentiert und der dritte Wert der Ausgangscharakteristik einen minimalen Wert repräsentiert.

6. Schaltvorrichtung (110) gemäß einem der vorangegangenen Ansprüche, **dadurch gekennzeichnet, dass** in der Grundstellung das Bedienelement (130) und die zumindest eine Federeinrichtung (260) kraftmäßig entkoppelt sind, in der ersten Betätigungsstellung eine Kraftübertragung zwischen dem Bedienelement (130) und der zumindest einen Federeinrichtung (260) minimal ist und in der zweiten Betätigungsstellung eine Kraftübertragung zwischen dem Bedienelement (130) und der zumindest einen Federeinrichtung (260) maximal ist.

7. Schaltvorrichtung (110) gemäß einem der vorangegangenen Ansprüche, **dadurch gekennzeichnet, dass** das Bedienelement (130) eine Taste, einen Schalter, eine Wipptaste, einen Wippschalter oder einen Schieber aufweist.

8. Steuersystem (100) für ein Fahrzeug, **dadurch gekennzeichnet, dass** das Steuersystem (100) folgende Merkmale aufweist:
eine Schaltvorrichtung (110) gemäß einem der vorangegangenen Ansprüche; und
ein Steuergerät (140), wobei die Schaltvorrichtung (110) mittels des zumindest einen Lichtleiters (120) datenübertragungsfähig mit dem Steuergerät (140) verbunden ist, wobei das Steuergerät (140) eine Einrichtung (142) zum Einkoppeln des Lichtsignals (222) mit der Eingangscharakteristik in den zumindest einen Lichtleiter (120) und eine Einrichtung (144) zum Erfassen der Ausgangscharakteristik des Lichtsignals (222) aus dem zumindest einen Lichtleiter (120) aufweist, wobei das Steuergerät (140) ausgebildet ist, um abhängig von einem Wert der Ausgangscharakteristik des Lichtsignals (222) ein Steuersignal (150) zu erzeugen.

9. Steuersystem (100) gemäß Anspruch 8, **dadurch gekennzeichnet, dass** das Steuergerät (140) ausgebildet ist, um das Steuersignal (150) an eine Schnittstelle zu einer Motorsteuervorrichtung und/oder an eine Schnittstelle zu einer Getriebesteuervorrichtung auszugeben.

10. Steuersystem (100) gemäß Anspruch 9, **dadurch gekennzeichnet, dass** das Steuergerät (140) ausgebildet ist, um ansprechend auf den zweiten Wert der Ausgangscharakteristik ein erstes Steuersignal (150) zu erzeugen, das ein Vorwahlsignal zum Vorwählen einer Getriebestufe repräsentiert, und ansprechend auf den dritten Wert der Ausgangscharakteristik ein zweites Steuersignal (150) zu erzeugen, das ein Schaltsignal zum Einstellen einer Getriebestufe repräsentiert.

11. Steuersystem (100) gemäß einem der Ansprüche 9 bis 10, **dadurch gekennzeichnet, dass** das Steuergerät (140) ausgebildet ist, um ansprechend auf den zweiten Wert der Ausgangscharakteristik ein erstes Steuersignal (150) zu erzeugen, das ein Motorstartsignal repräsentiert, und ansprechend auf den dritten Wert der Ausgangscharakteristik ein zweites Steuersignal (150) zu erzeugen, das ein Entriegelungssignal zum Lösen einer Getriebeverriegelung repräsentiert.

## Claims

1. Switching apparatus (110) for a control system (100) for a vehicle, wherein the switching apparatus (110) has the following features:
at least one light guide (120) for guiding a light signal (222), wherein on entering the switching apparatus (110) the light signal (222) has an input characteristic, and on exiting the switching apparatus (110) it has an output characteristic; and
an operator control element (130) for applying an activation force (131) to the switching apparatus (110), wherein the operator control element (130) can be moved between a basic position, a first activation position and a second activation position on account of the activation force (131), wherein the operator control element (130) has a setting device (132; 232; 432; 532; 632; 732A, 732B) for setting a characteristic of the light signal (222), wherein the setting device (132; 232; 432; 532; 632; 732A, 732B) is designed to set the output characteristic of the light signal (222) to the a first value in the basic position of the operator control element (130), to set the output characteristic of the light signal (222) to a second value in the first activation position, and to set the output characteristic of the light signal (222) to a third value in the second activation position, wherein the first value, the second value and the third value are different from one another, **characterized in that** the switching apparatus (110) has a continuous light guide as the at least one light guide (120) and at least one spring device (260) for applying a spring force, counter to the activation force (131), to the operator control element (130), wherein the spring device (260) is designed to regulate a multi-stage movement of the operator control element (130) between the basic position, the first activation position and the second activation position, wherein the setting device (132) has at least one pressure section (232) which is designed to change a curvature radius of the at least one light guide (120) depending on a position of the operator control element (130), wherein the light guide (120) is arranged between the at least one pressure section (232) and the spring device (260).

2. Switching apparatus (110) according to Claim 1, **characterized in that** the setting device (132) has at least one attenuator (432; 532; 732A, 732B) which is designed to at least partially transmit the light signal (222) in the at least one light guide (120) and/or at least partially attenuate or interrupt the light signal (222) depending on a position of the operator control element (130).

3. Switching apparatus (110) according to one of the preceding claims, **characterized in that** the setting device (132) has at least one further light guide (632) which is designed to at least partially transmit the light signal (222) in the at least one light guide (120) and/or at least partially divert the light signal (222) to the operator control element (130) depending on a position of the operator control element (130).

4. Switching apparatus (110) according to one of the preceding claims, **characterized in that** the input characteristic and the output characteristic of the light signal (222) represent a light intensity or a light current.

5. Switching apparatus (110) according to one of the preceding claims, **characterized in that** the first value of the output characteristic represents a maximum value, and the third value of the output characteristic represents a minimum value.

6. Switching apparatus (110) according to one of the preceding claims, **characterized in that** in the basic position the operator control element (130) and the at least one spring device (260) are decoupled in terms of force, in the first activation position a transmission of force between the operator control element (130) and the at least one spring device (260) is minimal, and in the second activation position a transmission of force between the operator control element (130) and the at least one spring device (260) is maximal.

7. Switching apparatus (110) according to one of the preceding claims, **characterized in that** the operator control element (130) has a push button key, a switch, a rocker key, a rocker switch or a slide.

8. Control system (100) for a vehicle, **characterized in that** the control system (100) has the following features:
a switching apparatus (110) according to one of the preceding claims; and
a control device (140), wherein the switching apparatus (110) is connected to the control device (140) by means of the at least one light guide (120) so as to be capable of transmitting data, wherein the control device (140) has a device (142) for inputting the light signal (222) with the input characteristic into the at least one light guide (120), and a device (144) for detecting the output characteristic of the light signal (222) from the at least one light guide (120), wherein the control device (140) is designed to generate a control signal (150) as a function of a value of the output characteristic of the light signal (222).

9. Control system (100) according to Claim 8, **characterized in that** the control device (140) is designed to output the control signal (150) to an interface with an engine control device and/or to an interface with a transmission control device.

10. Control system (100) according to Claim 9, **characterized in that** the control device (140) is designed to generate, in response to the second value of the output characteristic, a first control signal (150) which represents a pre-selection signal for preselecting a transmission stage, and to generate, in response to the third value of the output characteristic, a second control signal (150) which represents a switching signal for setting a transmission stage.

11. Control system (100) according to one of Claims 9 to 10, **characterized in that** the control device (140) is designed to generate, in response to the second value of the output characteristic, a first control signal (150) which represents an engine start signal, and to generate, in response to the third value of the output characteristic, a second control signal (150) which represents an unlocking signal for releasing a transmission lock.

## Revendications

1. Arrangement de commutation (110) pour un système de commande (100) pour un véhicule, l'arrangement de commutation (110) possédant les caractéristiques suivantes :
au moins une fibre optique (120) destinée à conduire un signal lumineux (222), le signal lumineux (222) possédant une caractéristique d'entrée lors d'une entrée dans l'arrangement de commutation (110) et une caractéristique de sortie lors d'une sortie de l'arrangement de commutation (110) ; et
un élément d'opération (130) destiné à induire une force d'actionnement (131) dans le dispositif de commutation (110), l'élément d'opération (130), du fait de la force d'actionnement (131), pouvant être déplacé entre une position de base, une première position d'actionnement et une deuxième position d'actionnement, l'élément d'opération (130) possédant un dispositif de réglage (132 ; 232 ; 432 ; 532 ; 632 ; 732A, 732B) servant à régler une caractéristique du signal lumineux (222), le dispositif de réglage (132 ; 232 ; 432 ; 532 ; 632 ; 732A, 732B) étant configuré pour régler la caractéristique de sortie du signal lumineux (222) à une première valeur dans la position de base de l'élément d'opération (130), régler la caractéristique de sortie du signal lumineux (222) à une deuxième valeur dans la première position d'actionnement et régler la caractéristique de sortie du signal lumineux (222) à une troisième valeur dans la deuxième position d'actionnement, la première valeur, la deuxième valeur et la troisième valeur étant différentes les unes des autres, **caractérisé en ce que** l'arrangement de commutation (110) possède comme l'au moins une fibre optique (120) une fibre optique continue et au moins un dispositif à ressort (260) destiné à appliquer à l'élément d'opération (130) une force de ressort opposée à la force d'actionnement (131), le dispositif à ressort (260) étant configuré pour réguler un mouvement en plusieurs paliers de l'élément d'opération (130) entre la position de base, la première position d'actionnement et la deuxième position d'actionnement, le dispositif de réglage (132) possédant au moins une portion de pression (232) qui est configurée pour, en fonction d'une position de l'élément d'opération (130), modifier un angle de courbure de l'au moins une fibre optique (120), la fibre optique (120) étant disposée entre l'au moins une portion de pression (232) et le dispositif à ressort (260).

2. Arrangement de commutation (110) selon la revendication 1, **caractérisé en ce que** le dispositif de réglage (132) possède au moins une portion d'amortissement (432 ; 532 ; 732A, 732B) qui est configurée pour, en fonction d'une position de l'élément d'opération (130), laisser passer le signal lumineux (222) au moins partiellement dans l'au moins une fibre optique (120) et/ou l'atténuer au moins partiellement ou l'interrompre.

3. Arrangement de commutation (110) selon l'une des revendications précédentes, **caractérisé en ce que** le dispositif de réglage (132) possède au moins une fibre optique supplémentaire (632) qui est configurée pour, en fonction d'une position de l'élément d'opération (130), laisser passer le signal lumineux (222) au moins partiellement dans l'au moins une fibre optique (120) et/ou le dévier au moins partiellement vers l'élément d'opération (130).

4. Arrangement de commutation (110) selon l'une des revendications précédentes, **caractérisé en ce que** la caractéristique d'entrée et la caractéristique de sortie du signal lumineux (222) représentent une intensité lumineuse ou un courant lumineux.

5. Arrangement de commutation (110) selon l'une des revendications précédentes, **caractérisé en ce que** la première valeur de la caractéristique de sortie représente une valeur maximale et la troisième valeur de la caractéristique de sortie représente une valeur minimale.

6. Arrangement de commutation (110) selon l'une des revendications précédentes, **caractérisé en ce que** dans la position de base, l'élément d'opération (130) et l'au moins un dispositif à ressort (260) sont désaccouplés du point de vue de la force, dans la première position d'actionnement, une transmission de force entre l'élément d'opération (130) et l'au moins un dispositif à ressort (260) est minimale et dans la deuxième position d'actionnement, une transmission de force entre l'élément d'opération (130) et l'au moins un dispositif à ressort (260) est maximale.

7. Arrangement de commutation (110) selon l'une des revendications précédentes, **caractérisé en ce que** l'élément d'opération (130) possède une touche, un commutateur, une touche à bascule, un commutateur à bascule ou un curseur.

8. Système de commande (100) pour un véhicule, **caractérisé en ce que** le système de commande (100) possède les caractéristiques suivantes :
un arrangement de commutation (110) selon l'une des revendications précédentes, et
un contrôleur (140), l'arrangement de commutation (110) étant relié au contrôleur (140) au moyen de l'au moins une fibre optique (120), le contrôleur (140) possédant un dispositif (142) servant à injecter le signal lumineux (222) ayant la caractéristique d'entrée dans l'au moins une fibre optique (120) et un dispositif (144) destiné à acquérir la caractéristique de sortie du signal lumineux (222) issu de l'au moins une fibre optique (120), le contrôleur (140) étant configuré pour générer un signal de commande (150) en fonction d'une valeur de la caractéristique de sortie du signal lumineux (222).

9. Système de commande (100) selon la revendication 8, **caractérisé en ce que** le contrôleur (140) est configuré pour délivrer le signal de commande (150) au niveau d'une interface vers un arrangement de commande de moteur et/ou au niveau d'une interface vers un arrangement de commande de boîte de vitesses.

10. Système de commande (100) selon la revendication 9, **caractérisé en ce que** le contrôleur (140) est configuré pour, en réaction à la deuxième valeur de la caractéristique de sortie, générer un premier signal de commande (150) qui représente un signal de présélection servant à présélectionner un rapport de boîte de vitesses et, en réaction à la troisième valeur de la caractéristique de sortie, générer un deuxième signal de commande (150) qui représente un signal de changement de rapport servant à régler un rapport de boîte de vitesses.

11. Système de commande (100) selon l'une des revendications 9 à 10, **caractérisé en ce que** le contrôleur (140) est configuré pour, en réaction à la deuxième valeur de la caractéristique de sortie, générer un premier signal de commande (150) qui représente un signal de démarrage de moteur et, en réaction à la troisième valeur de la caractéristique de sortie, générer un deuxième signal de commande (150) qui représente un signal de déverrouillage servant à libérer un verrouillage de boîte de vitesses.
